# FASCICULE DE BREVET EUROPEEN

(11) **EP 2 503 865 B1**
(45) Date de publication et mention de la délivrance du brevet: **02.07.2014**
(21) Numéro de dépôt: 12160320.3
(22) Date de dépôt: 20.03.2012
(51) Int. Cl.: H05K 7/14, B64D 43/00

(54) **Dispositif de connexion electrique et mecanique d'un boitier electronique dans un bati**
Elektrische und mechanische Verbindungsvorrichtung eines elektronischen Schaltkastens in einem Unterbau
Device for electrical and mechanical connection of an electronic box in a frame

(30) Priorité: 24.03.2011 FR 1100885
(43) Date de publication de la demande: 26.09.2012
(73) Titulaire: Thales, 92200 Neuilly Sur Seine (FR)
(72) Inventeur: Klaver, Jean-Noël, 33600 Pessac (FR); Rauscent, Eric, 33310 Lormont (FR); Cavailles, Christian, 27180 Saint Sebastien De Morsent (FR); Fabre, Stéphane, 33300 Bordeaux (FR)
(74) Mandataire: Bréda, Jean-Marc

(56) Documents cités:
- EP-A1- 0 323 926
- WO-A1-2008/040783
- FR-A1- 2 787 282
- FR-A1- 2 846 510
- FR-A1- 2 938 022
- US-A- 5 307 238

## Description

Le domaine de l'invention est celui des dispositifs de connexion électrique et mécanique de boîtiers électroniques dans des bâtis permettant d'assurer une connexion sécurisée. Le domaine d'application privilégié est celui de l'aéronautique et en particulier celui des planches de bord d'aéronef comportant plusieurs écrans de visualisation. Cependant, ce dispositif peut avoir un grand nombre d'applications, en particulier dans les domaines de l'électronique professionnelle qui nécessitent des connexions sécurisées.

Dans un certain nombre d'applications, un opérateur de maintenance doit pouvoir connecter et fixer un boîtier électronique avec un autre élément de manière simple et sécurisée, sans pouvoir se tromper. Le système de connexion doit également répondre à des normes et des réglementations très strictes. Dans le domaine aéronautique, les principales contraintes d'un dispositif de connexion sont:
- Montage et démontage du boîtier sans outils;
- Très bonne tenue mécanique de l'ensemble. Dans le domaine aéronautique, le boîtier doit pouvoir résister à un choc correspondant à une accélération de 11 G pendant une durée de 6ms, ce que l'on appelle un « crash safety »;
- Tenue aux environnements sévères comme les vibrations, les températures extrêmes et l'humidité;
- Poignée de transport obligatoire ;
- Géométrie arrondie des interfaces mécaniques ;
- Utilisation de matériaux amagnétiques et non inflammables;
- Bonne visibilité du dispositif de façon à vérifier que le montage est correctement effectué;
- Système de détrompage obligatoire ;
- Quand elles existent, accès aisé aux commandes du boîtier telles que des boutons de commande;
- Totale visibilité de l'image si le boîtier est un dispositif de visualisation.

Des systèmes de connexion ont été développés pour répondre à ces différents impératifs. Ces systèmes comprennent généralement une poignée assurant les fonctions de transport du boîtier électronique et de verrouillage encore appelé « rackage » du boîtier électronique dans son bâti.

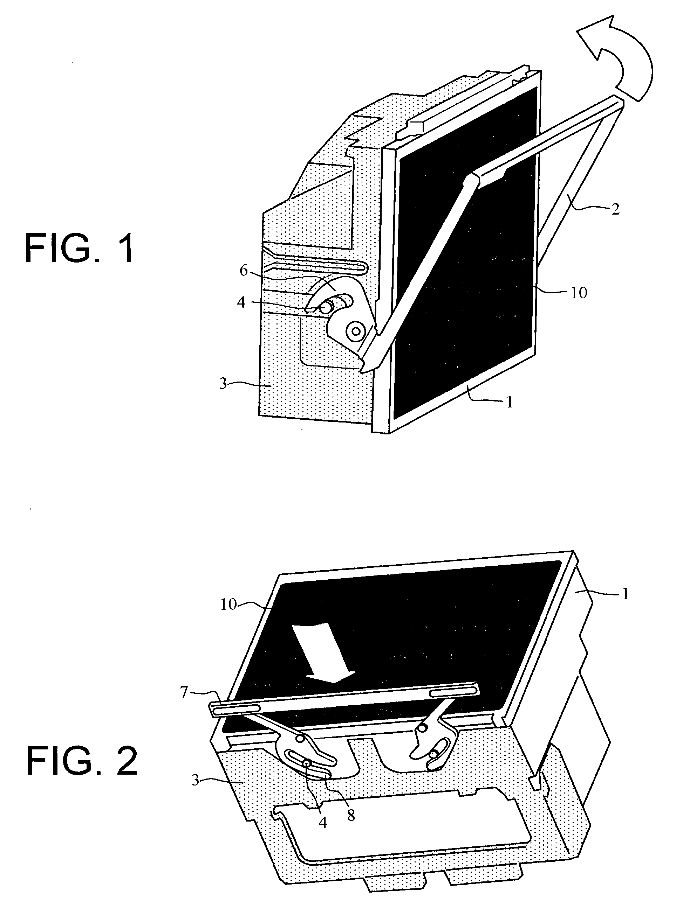

Ainsi, le document FR 2 938 022 intitulé « Dispositif comportant une poignée de verrouillage à came excentrique » propose un premier système de connexion. La figure 1 représente ce système de connexion. Le boîtier électronique 1 qui comprend un écran de visualisation 10 est équipé d'une poignée multifonction 2 comportant des cames de verrouillage 6. Des connecteurs non visibles sur la figure 1 sont situés sur l'arrière du boîtier électronique. La connexion se fait par l'intermédiaire d'une chaise 3 équipée de pions 4 montés sur ressorts. Une fois le boîtier électronique 1 inséré dans la chaise 3, l'action sur la poignée 2 vient tirer sur les pions 4 au moyen des cames 6 et contraint le boîtier électronique 1 à finir sa course et à établir la connexion à la fois électrique et mécanique. La flèche blanche semi-circulaire indique le mouvement de la poignée de verrouillage 2 pendant la mise en place du boîtier.

La figure 2 représente une variante du dispositif précédent. Dans ce dispositif de connexion, la chaise 3 est plus compacte et la poignée 2 du dispositif précédent est remplacée par un système de tiroir 7. L'action sur ce tiroir entraîne en rotation deux pinces 8 qui viennent saisir les pions 4 de la chaise, montés sur ressorts. Une fois le tiroir 7 refermé, la connexion est établie. La flèche blanche droite indique le mouvement du tiroir 7 pendant la mise en place du boîtier 1.

Enfin, la publication WO 2008/040783 intitulé «Dispositif de connexion d'un boîtier électronique dans un support mis en place par au moins deux mouvements de translation » propose un système de connexion comprenant un support muni de moyens de guidage en translation du boîtier électronique et des moyens de translation ou de rotation permettant d'insérer le boîtier électronique dans le bâti.

Ces systèmes présentent plusieurs défauts. L'encombrement de l'interface de connexion est très important. Ces systèmes induisent également des contraintes apportées par le câblage situé sur la partie arrière du boîtier électronique. Dans le premier système, le bras de levier étant faible, l'effort à fournir sur la poignée par l'opérateur pour installer le boîtier électronique est important. De plus, cette poignée est renforcée pour éviter toute déformation. Enfin, l'effort de serrage n'étant pas parallèle à l'effort nécessaire pour enficher les connecteurs situés à l'arrière de l'écran, un mouvement de rotation parasite de la connexion apparaît que l'on doit compenser avec des cales. Toutes ces modifications engendrent des coûts supplémentaires.

Le dispositif de connexion selon l'invention ne présente pas les inconvénients précédents. Ce dispositif présente deux innovations importantes par rapport aux dispositifs de l'art antérieur. La connexion est toujours assurée par une poignée, cependant celle-ci est disposée à l'arrière du boîtier, dégageant totalement la face avant du boîtier. Enfin, la connectique utilisée permet une connexion en latéral parallèlement à la face avant, ce qui réduit considérablement l'encombrement de la connectique et diminue également l'effort de serrage qui se situe maintenant dans l'axe des connecteurs. Une connectique ou un connecteur possède des broches de connexion soit mâles, soit femelles. Ces broches sont toutes orientées selon une certaine direction. On entend par connexion en latéral une connectique dont la direction des broches est parallèle à la face avant du boîtier comportant cette connectique. Lorsqu'il s'agit d'un dispositif de visualisation, la face avant est l'écran de visualisation.

Plus précisément, l'invention a pour objet un dispositif de connexion électrique et mécanique d'un boîtier électronique dans un bâti, le boîtier de forme sensiblement parallélépipédique comportant une face avant, quatre côtés et une face arrière, le bâti comprenant une ouverture rectangulaire de dimensions voisines de celles de la face avant, le boîtier électronique comprenant un premier connecteur et le bâti comprenant un second connecteur complémentaire du premier connecteur, **caractérisé en ce que** le dispositif de connexion comporte:
- Montés sur le bâti,
   ∘ deux supports identiques situés de part et d'autre de deux des côtés de l'ouverture, le second connecteur étant monté sur lesdits supports en rotation libre et;
   ∘ des premiers moyens de fixation;
- Sur un des côtés du boîtier,
   ∘ un logement comprenant le premier connecteur, ledit logement agencé de façon à recevoir le second connecteur et ;
   ∘ des seconds moyens de fixation complémentaires des premiers moyens de fixation et agencés de façon que le second connecteur étant disposé dans le logement du boîtier, les seconds moyens de fixation bloquent ledit second connecteur dans le boîtier.

Avantageusement, le dispositif comporte :
- Montés sur le bâti, des troisièmes moyens de fixation ;
- Montés sur la face avant du boîtier, des quatrièmes moyens de fixation complémentaires des troisièmes moyens de fixation et agencés de façon que, lorsque le second connecteur est bloqué dans son logement, les quatrièmes moyens de fixation bloquent le boîtier dans le bâti.

Avantageusement, les premiers moyens de fixation sont une poignée de verrouillage à cames montée également en rotation libre sur les supports, chaque came comportant, au niveau de chaque support, une ouverture, les seconds moyens de fixation étant deux doigts de verrouillage complémentaires des ouvertures des deux cames. En position verrouillée, la poignée de verrouillage est disposée le long de la face arrière du boîtier.

Enfin, le bâti est un bâti de planche de bord d'aéronef et le boîtier est un dispositif de visualisation, la face avant du boîtier étant l'écran de visualisation.

L'invention sera mieux comprise et d'autres avantages apparaîtront à la lecture de la description qui va suivre donnée à titre non limitatif et grâce aux figures annexées parmi lesquelles :
La figure 1 déjà commentée représente un premier dispositif selon l'art antérieur;
La figure 2 déjà commentée représente un second dispositif selon l'art antérieur;
La figure 3 représente une vue générale du dispositif de connexion selon l'invention avant verrouillage ;
La figure 4 représente une vue partielle du dispositif de connexion selon l'invention pendant le verrouillage ;
La figure 5 représente une vue partielle du dispositif de connexion selon l'invention après le verrouillage.

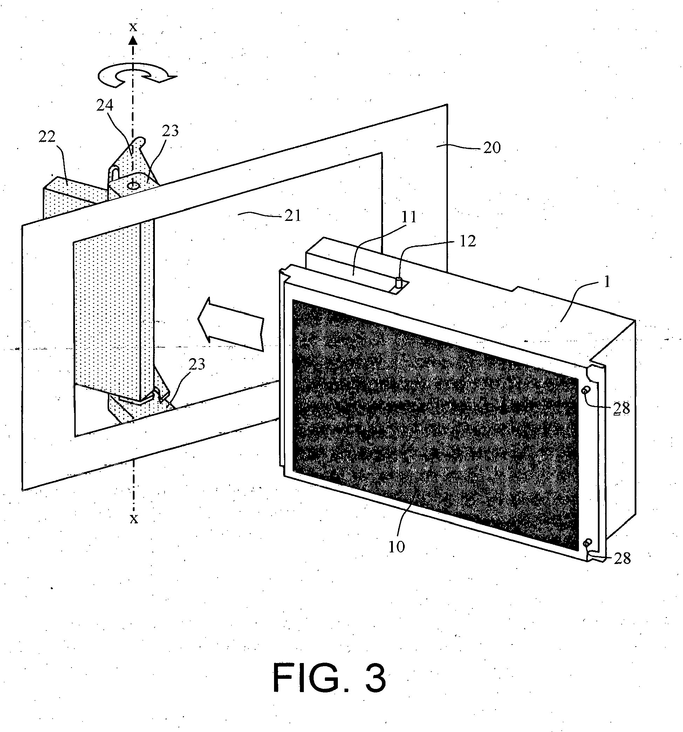

A titre d'exemple non limitatif, la figure 3 représente une vue générale du dispositif de connexion selon l'invention avant verrouillage.

Le boîtier 1 à connecter dans le bâti 20 est de forme sensiblement parallélépipédique et comporte une face avant, quatre côtés et une face arrière. Ce boîtier est, dans le cas présent, un dispositif de visualisation comportant en face avant un écran de visualisation 10 et le bâti est une planche de bord d'aéronef. Le boîtier électronique comprend un premier connecteur disposé en latéral au fond d'un logement 11. Le logement 11 est disposé sur un des côtés du boîtier 1. Le bâti comporte également deux doigts de verrouillage 12 situés sur deux côtés opposés du bâti et de part et d'autre du logement 11.

Le bâti 20 dans lequel ce boîtier se monte et se connecte comporte une ouverture 21 rectangulaire de dimensions voisines de celles de la face avant 10. Il comporte un second connecteur 22 complémentaire du premier connecteur du boîtier. Ce second connecteur est monté dans un carter qui peut s'encastrer parfaitement dans le logement 11.

Le bâti 20 comporte également deux supports identiques 23 situés de part et d'autre de deux des côtés de l'ouverture 21, le second connecteur 22 est monté sur les supports 23 en rotation libre sur des axes 27 selon un axe de rotation xx disposé parallèlement au plan de l'ouverture et parallèlement à l'un des côtés de l'ouverture 21. Ces supports 23 peuvent être soit usinés dans la masse du bâti, soit rapportés et fixés sur le bâti.

Le bâti comporte enfin, monté sur les mêmes supports 23 et sur les mêmes axes 27 une poignée de verrouillage 24 comprenant deux cames 25, chaque came située au niveau d'un support 23. Cette poignée constitue un dispositif de levier à effet de démultiplication avec une rotation autour de l'axe xx. Chaque came 25 comporte une ouverture 26 dont le profil est calculé de façon à pouvoir exercer une force variable et déterminée sur le doigt de verrouillage 12 du bâti lorsqu'il est disposé dans ladite ouverture 26 et lorsque l'on tourne la poignée de verrouillage autour de son axe de rotation.

Le dispositif de connexion selon l'invention nécessite une connectique disposée en latéral sur le boîtier et non pas sur la face arrière du boîtier comme c'est le cas sur les boîtiers des figures 1 et 2. Ce type de connectique se développe actuellement très rapidement. En effet, dues aux incessantes évolutions technologiques, les écrans de visualisation à écran plat s'affinent d'année en année. Les connecteurs disparaissent de l'arrière des équipements pour se retrouver sur les côtés de façon à s'inscrire dans la faible épaisseur de l'écran. Ainsi, le dispositif de connexion selon l'invention prend en compte cette évolution inéluctable.

Le procédé de montage et de verrouillage du boîtier dans son bâti est simple et comprend les trois étapes suivantes.

Dans une première étape, le boîtier électronique 1 est engagé par un utilisateur dans le bâti selon un mouvement en translation indiqué par la flèche blanche de la figure 3 de façon que le second connecteur du bâti entre dans le logement 11 du boîtier. Lors de cette étape, le boîtier électronique est maintenu à l'aide des deux mains de l'utilisateur. Lorsque le premier et le second connecteur sont suffisamment engagés, une main suffit alors pour maintenir le boîtier électronique 1. Les doigts haut et bas 12 du boîtier sont alors en face des ouvertures des cames haute et basse de la poignée.

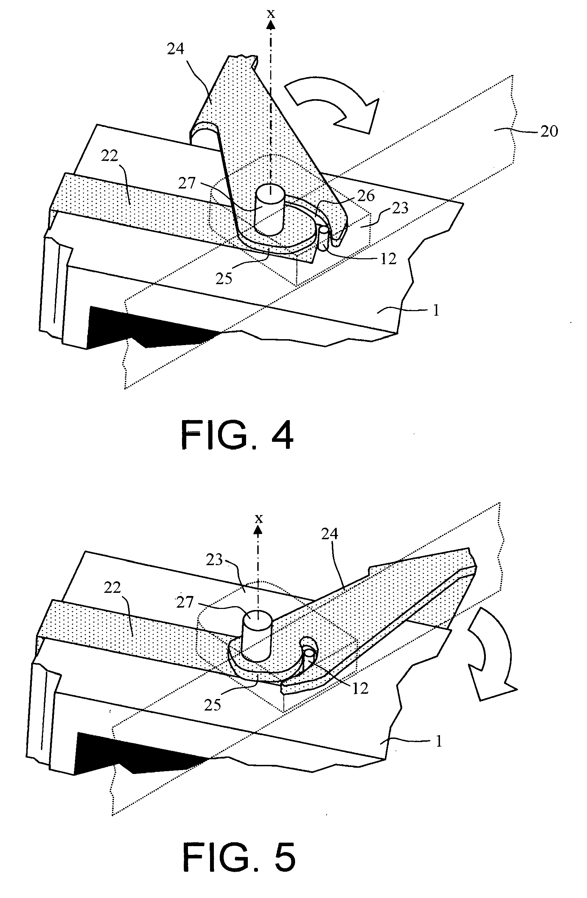

Dans une seconde étape illustrée sur les figures 4 et 5, l'utilisateur tourne la poignée de verrouillage. Ces figures sont des vues partielles et représentent la position de la poignée à deux instants du verrouillage en début et en fin de manoeuvre. Sur ces deux figures et de façon à les rendre plus claires, le bâti 20 et le support 23 sont représentés en transparence par des pointillés de façon à laisser apparaître une des deux cames de la poignée. La rotation de la poignée de verrouillage 24 avec dispositif de levier à effet de démultiplication permet de finir d'accoupler le premier et le second connecteur. La rotation de la poignée est illustrée, sur ces figures, par une flèche blanche semi-circulaire. Pendant cette opération, l'utilisateur exerce une force suffisante de façon que chaque doigt de verrouillage 12 parcoure l'ouverture 26 d'une came 25. A la fin de cette seconde étape, la poignée de verrouillage se retrouve alors en butée sur l'arrière du boîtier 1 dans un logement prévu à cet effet. Le second connecteur est alors bloqué et en butée dans son logement. Le boîtier peut alors tourner dans le bâti en rotation autour de l'axe xx.

Dans une troisième et dernière étape, l'utilisateur fait tourner le boîtier autour de l'axe de rotation xx et vient plaquer le boîtier contre le bâti de façon que la face avant 10 affleure l'ouverture 21. Une fois le boîtier électronique 1 en appui sur le bâti, un verrouillage a lieu afin de maintenir cette position. Ce verrouillage peut par exemple être assuré par des vis à molette 28 comme représenté sur la figure 3 ou tout autre système de verrouillage rapide.

Le dispositif de connexion selon l'invention a de multiples avantages.

Le système est simple et léger et peu encombrant. L'encombrement des connecteurs est compris dans le volume du boîtier électronique, rendant ainsi disponible la totalité de l'arrière du boîtier électronique pour d'autres connectiques spécifiques. Sur une application sur planche de bord d'aéronef, le gain d'encombrement dû à la connectique latérale est d'environ 300 millimètres sur la profondeur de la planche de bord. La connectique est compatible des nouveaux écrans de visualisation possédant une connectique latérale. De plus, la poignée de verrouillage est à l'arrière du boîtier et n'est absolument pas apparente lorsque le boîtier est monté dans son bâti, ce qui est visuellement très favorable.

Le dispositif de connexion présente une bonne compatibilité électro-magnétique dans la mesure où le connecteur est isolé dans son logement.

De plus, la mise en oeuvre du procédé de connexion est facile. Elle ne nécessite aucun outillage. Elle comporte trois étapes simples qui sont :
- une translation, pour engager le connecteur du bâti dans le logement du boîtier;
- une action sur la poignée de verrouillage pour assurer une connexion sécurisée entre les deux connecteurs ;
- Enfin, une rotation pour mettre le boîtier en butée et assurer le maintien en position opérationnelle de l'équipement.

## Revendications

1. Dispositif de connexion électrique et mécanique d'un boîtier électronique (1) dans un bâti (20), le boîtier de forme sensiblement parallélépipédique comportant une face avant (10), quatre côtés et une face arrière, le bâti comprenant une ouverture (21) rectangulaire de dimensions voisines de celles de la face avant (10), le boîtier électronique comprenant un premier connecteur et le bâti comprenant un second connecteur (22) complémentaire du premier connecteur, **caractérisé en ce que** le dispositif de connexion comporte :
- Montés sur le bâti,
∘ deux supports (23) identiques situés de part et d'autre de deux des côtés de l'ouverture (21), le second connecteur (22) étant monté sur lesdits supports (23) en rotation libre et ;
∘ des premiers moyens de fixation (24) ;
- Sur un des côtés du boîtier,
∘ un logement (11) comprenant le premier connecteur, ledit logement (11) agencé de façon à recevoir le second connecteur (22) et ;
∘ des seconds moyens de fixation (12) complémentaires des premiers moyens de fixation (24) et agencés de façon que le second connecteur (22) étant disposé dans le logement (11) du boîtier électronique (1), les seconds moyens de fixation bloquent ledit second connecteur dans le boîtier électronique (1).

2. Dispositif de connexion électrique et mécanique selon la revendication 1, **caractérisé en ce que** le dispositif comporte :
- Montés sur le bâti, des troisièmes moyens de fixation ;
- Montés sur la face avant du boîtier, des quatrièmes moyens de fixation (28) complémentaires des troisièmes moyens de fixation et agencés de façon que, lorsque le second connecteur est bloqué dans son logement, les quatrièmes moyens de fixation bloquent le boîtier (1) dans le bâti (20).

3. Dispositif de connexion électrique et mécanique selon la revendication 1, **caractérisé en ce que** les premiers moyens de fixation sont une poignée de verrouillage (24) à cames (25) montée également en rotation libre sur les supports (23), chaque came (25) comportant, au niveau de chaque support (23), une ouverture (26), les seconds moyens de fixation étant deux doigts de verrouillage (12) complémentaires des ouvertures (26) des deux cames (25).

4. Dispositif de connexion électrique et mécanique selon la revendication 3, **caractérisé en ce qu'**en position verrouillée, la poignée de verrouillage (24) est disposée le long de la face arrière du boîtier électronique (1).

5. Dispositif de connexion électrique et mécanique selon l'une des revendications précédentes, **caractérisé en ce que** le bâti (20) est un bâti de planche de bord d'aéronef et **en ce que** le boîtier électronique (1) est un dispositif de visualisation, la face avant (10) étant l'écran de visualisation.

## Patentansprüche

1. Vorrichtung zum elektrischen und mechanischen Verbinden eines Elektronikgeräts (1) in einem Rahmen (20), wobei das Gerät im Wesentlichen quaderförmig ist und eine Frontfläche (10), vier Seiten- und eine Rückfläche hat, wobei der Rahmen eine rechteckige Öffnung (21) mit Abmessungen aufweist, die denen der Frontfläche (10) ähnlich sind, wobei das Elektronikgerät einen ersten Verbinder umfasst und der Rahmen einen zweiten Verbinder (22) komplementär zum ersten Verbinder umfasst, **dadurch gekennzeichnet, dass** die Verbindungsvorrichtung Folgendes umfasst:
- an dem Rahmen montiert:
∘ zwei identische Auflagen (23), eine auf jeder von zwei der Seiten der Öffnung (21), wobei der zweite Verbinder (22) frei drehbar auf den Auflagen (23) montiert ist; und
∘ erste Befestigungsmittel (24);
- auf einer der Seiten des Geräts:
∘ eine Aufnahme (11), die den ersten Verbinder umfasst, wobei die Aufnahme (11) so angeordnet ist, dass sie den zweiten Verbinder (22) aufnimmt; und
∘ zweite Befestigungsmittel (12) komplementär zu den ersten Befestigungsmitteln (24) und so angeordnet, dass, wenn sich der zweite Verbinder (22) in der Aufnahme (11) des elektronischen Geräts (1) befindet, die zweiten Befestigungsmittel den zweiten Verbinder in dem Elektronikgerät (1) arretieren.

2. Elektrische und mechanische Verbindungsvorrichtung nach Anspruch 1, **dadurch gekennzeichnet, dass** die Vorrichtung Folgendes umfasst:
- am Rahmen montierte dritte Befestigungsmittel;
- an der Frontfläche des Geräts montierte vierte Befestigungsmittel (28) komplementär zu den dritten Befestigungsmitteln und so angeordnet, dass, wenn der zweite Verbinder in seiner Aufnahme arretiert ist, die vierten Befestigungsmittel das Gerät (1) in dem Rahmen (20) arretieren.

3. Elektrische und mechanische Verbindungsvorrichtung nach Anspruch 1, **dadurch gekennzeichnet, dass** die ersten Befestigungsmittel ein Verriegelungsgriff (24) mit Nocken (25) sind, ebenfalls frei drehbar an den Auflagen (23) montiert, wobei jede Nocke (25) an jeder Auflage (23) eine Öffnung (26) aufweist, wobei die zweiten Befestigungsmittel Verriegelungsfinger (12) komplementär zu den Öffnungen (26) der zwei Nocken (25) sind.

4. Elektrische und mechanische Verbindungsvorrichtung nach Anspruch 3, **dadurch gekennzeichnet, dass** der Verriegelungsgriff (24) in der verriegelten Position entlang der Rückseite des Elektronikgeräts (1) angeordnet ist.

5. Elektrische und mechanische Verbindungsvorrichtung nach einem der vorherigen Ansprüche, **dadurch gekennzeichnet, dass** der Rahmen (20) ein Rahmen eines Luftfahrzeuginstrumentenbretts ist, und dadurch, dass das Elektronikgerät (1) eine Anzeigevorrichtung ist, wobei die Frontfläche (10) der Anzeigeschirm ist.

## Claims

1. A device for electrically and mechanically connecting an electronic unit (1) in a frame (20), said unit being of substantially parallelepiped shape and comprising a front face (10), four sides and a rear face, said frame comprising a rectangular opening (21), the dimensions of which are similar to those of said front face (10), said electronic unit comprising a first connector and said frame comprising a second connector (22) as a counterpart of said first connector, **characterised in that** said connection device comprises:
- mounted on said frame:
∘ two identical supports (23) located either side of two of the sides of said opening (21), said second connector (22) being mounted on said supports (23) in a freely rotatable manner; and
∘ first fixing means (24);
- on one side of said unit:
∘ a housing (11) comprising said first connector, said housing (11) being arranged so as to receive said second connector (22); and
∘ second fixing means (12) as a counterpart of said first fixing means (24) and arranged so that, with said second connector (22) being disposed inside said housing (11) of said electronic unit (1), said second fixing means block said second connector inside said electronic unit (1).

2. The electrical and mechanical connection device according to claim 1, **characterised in that** said device comprises:
- third fixing means mounted on said frame;
- fourth fixing means (28), mounted on said front face of said unit, as a counterpart of said third fixing means and arranged so that, when said second connector is blocked in its housing, said fourth fixing means block said unit (1) inside said frame (20).

3. The electrical and mechanical connection device according to claim 1, **characterised in that** said first fixing means are a locking handle (24) with cams (25) also mounted on said supports (23) in a freely rotatable manner, each cam (25) comprising an opening (26) on each support (23), said second fixing means being locking fingers (12) as counterparts of said openings (26) of said two cams (25).

4. The electrical and mechanical connection device according to claim 3, **characterised in that** in the locked position said locking handle (24) is disposed along said rear face of said electronic unit (1).

5. The electrical and mechanical connection device according to any one of the preceding claims, **characterised in that** said frame (20) is an aircraft instrument panel frame, and **in that** said electronic unit (1) is a display device, with said front face (10) being the display screen.
